# EUROPÄISCHE PATENTANMELDUNG

(11) **EP 2 177 645 A1**
(43) Veröffentlichungstag der Anmeldung: **21.04.2010**
(21) Anmeldenummer: 09011960.3
(22) Anmeldetag: 19.09.2009
(51) Int. Cl.: C23C 14/04, D21H 21/40, H05K 3/04

(54) **Verfahren zur Strukturierung von anorganischen oder organischen Schichten**

(30) Priorität: 29.09.2008 AT 15082008
(71) Anmelder: Hueck Folien Ges.m.b.H., 4342 Baumgartenberg (AT); Plastic Electronic, 4030 Linz (AT)
(72) Erfinder: Schmidegg, Klaus, 4020 Linz (AT); Rinnerbauer, Veronika, 4040 Linz (AT); Montaigne, Ramil Alberto, 4020 Linz (AT); Marjanovic, Nenad, 4040 Linz (AT)
(74) Vertreter: Landgraf, Elvira

(57) **Zusammenfassung**

Die Erfindung betrifft ein Verfahren zur Herstellung partieller anorganischer oder organischer Strukturen, gekennzeichnet durch folgende Verfahrensschritte:
a)Bereitstellen eines ersten Trägersubstrats, das gegebenenfalls bereits eine vollflächige oder partielle Beschichtung aufweisen kann,
b) ggf. Aufbringung einer partiellen Releaseschicht, die zur Schicht a) eine geringere Haftung aufweist, als die Schicht c) zur Schicht a), wobei die partielle Releaseschicht ein negatives Abbild der strukturierten Schicht darstellt,
c) vollflächige Aufbringung einer oder mehrerer zu strukturierende(r) Schicht(en) mittels eines Beschichtungsverfahrens
d) ggf. registergenaue Bedruckung der Schicht c) mit einem Kaschierkleber oder einem Heißsiegellack, der deckungsgleich mit der Schicht b) erfolgt, bzw. ein negatives Abbild der zu strukturierenden Schicht bildet
e) ggf Kaschieren des Schichtaufbaus a) - d) mit einem zweiten Trägersubstrat,
f) Abziehen des zweiten Trägersubstrats, wobei die nicht mit Releaseschicht und Kaschierkleber bzw. Heißsiegellack beschichteten

Bereich auf dem ersten Trägersubstrat haften bleiben.

## Beschreibung

Die Erfindung betrifft ein Verfahren zur Herstellung von strukturierten anorganischen oder organischen Schichten, wobei weder die anorganischen oder organischen Schichten noch die unter dieser Schicht liegenden Schichten bzw. das unter dieser Schicht liegende Trägersubstrat beschädigt oder beeinflusst werden.

Verfahren zur Herstellung von strukturierten Schichten auf Trägersubstraten sind bekannt.

So ist beispielsweise aus EP 1 291 463 A ein Verfahren zur partiellen Metallisierung von Trägersubstraten bekannt, wobei auf ein Trägersubstrat vorerst eine partielle Bedruckung mit einer vorzugsweise hochpigmentierten Farbe aufgebracht wird, anschließend das Substrat vollflächig mit einer metallischen Beschichtung versehen wird, worauf die partielle pigmentierte Farbe mittels eines Waschvorgangs mit der in diesen Bereichen darüber liegenden metallischen Beschichtung mittels eines Waschverfahrens, gegebenenfalls mit mechanischer Unterstützung entfernt wird.
Substrate bzw. Beschichtungen, die gegen die Waschflüssigkeit nicht beständig sind, können mit diesem Verfahren nicht strukturiert werden.

Aus WO 2007/090586 ist ein Verfahren zur Herstellung von partiell metallisierten Trägersubstraten bekannt, gekennzeichnet durch folgende Verfahrensschritte:
a) Bereitstellen eines ersten Trägersubstrats
b) partielles Bedrucken oder Beschichten des Trägersubstrats mit einem auf dem Trägersubstrat nur schwach haftenden Lack
c) Aufbringen einer vollflächigen metallischen Schicht
d) Kaschieren gegen ein klebebeschichtetes zweites Trägersubstrat und
e) Ablösen dieses zweiten klebebeschichteten Trägersubstrats,
wodurch der schwach haftende Lack mit der darüberliegenden metallischen Schicht vom ersten Trägersubstrat abgelöst wird und so eine strukturierte metallische Schicht auf dem ersten Trägersubstrat zurückbleibt.
Bei diesem Verfahren kann das klebebeschichtete zweite Trägersubstrat in Kontakt mit jenen Bereichen, die auf dem ersten Trägersubstrat verbleiben sollen, kommen und dadurch diese Schicht beeinträchtigen.

Ferner ist es möglich, strukturierte Schichten durch vorerst vollflächiges Bedampfen oder Beschichten eines Trägersubstrats und anschließende partielle Entfernung der Beschichtung mittels eines Ätzmediums herzustellen. Auch bei diesem Verfahren besteht die Gefahr der Beeinträchtigung oder sogar Zerstörung der darunterliegenden Schichten durch das Ätzmittel.

Eine vollflächig aufgebrachte organische oder anorganische Schicht kann auch durch Laserablation strukturiert werden, wobei dieses Verfahren relativ zeitaufwendig und dadurch nur bedingt Rolle-zu-Rolle-tauglich ist und zudem hohe Investitionskosten erfordert.

Ein weiteres bekanntes Verfahren zur Herstellung strukturierter Schichten ist das Auflegen einer Maske ("Schattenmaske") auf das zu bedampfende Trägersubstrat bzw. auf die zu bedampfenden Schichten. Die Maske besteht aus einem dünnen Metallblech bzw. einer dünnen Metallfolie, die Öffnungen in Form der zu beschichtenden Berieche enthält. Beim Aufdampfen wird das Substrat nur an den Stellen beschichtet, an denen die Maske durchlässig ist. Anschließend wird die Maske entfernt.
Nachteil dieses Verfahrens ist es, dass bei nicht korrektem Aufliegen der Maske auf dem zu bedampfenden Substrat ein so genanntes "Hinterdampfen" der Maske stattfindet und dadurch Konturen nicht exakt hergestellt werden können.
Für ein Rolle-zu-Rolle Verfahren ist diese Methode ebenfalls nur bedingt geeignet, da entweder die Bahn in periodischen Abständen gestoppt werden muss um die Maske zu positionieren und planar auflegen zu können bzw. eine zylindrische Maske verwendet werden muss, in deren Zentrum sich der eigentliche Verdampfer befindet. Beide Verfahren sind sowohl technisch komplex als auch zeitaufwendig.
Darüberhinaus muss die Maske selbsttragend sein und über die gesamte Fläche durchgehende Elemente aufweisen, wodurch die Designmöglichkeiten erheblich eingeschränkt werden.

Aufgabe der Erfindung war es daher, ein Verfahren zur Strukturierung anorganischer oder organischer Schichten auf einem Trägersubstrat oder einer Schicht bereitzustellen, das die Nachteile der bekannten Verfahren vermeidet.

Gegenstand der Erfindung ist daher ein Verfahren zur Herstellung partieller anorganischer oder organischer Strukturen, gekennzeichnet durch folgende Verfahrensschritte:
a) Bereitstellen eines ersten Trägersubstrats, das gegebenenfalls bereits eine oder mehrere vollflächige oder partielle Beschichtungen aufweisen kann,
b) ggf. Aufbringung einer partiellen Releaseschicht, die zur Schicht a) eine geringere Haftung aufweist als die Schicht c) zur Schicht a), wobei die partielle Releaseschicht ein negatives Abbild der strukturierten Schicht darstellt,
c) vollflächige Aufbringung einer oder mehrerer zu strukturierende(r) Schicht(en) mittels eines Beschichtungsverfahrens
d) ggf. registergenaue Bedruckung der Schicht c) mit einem Kaschierkleber oder einem Heißsiegellack, der deckungsgleich mit der Schicht b) erfolgt bzw. ein negatives Abbild der zu strukturierenden Schicht bildet
e) ggf. Kaschieren des Schichtaufbaus a) - d) mit einem zweiten Trägersubstrat,
f) Abziehen des zweiten Trägersubstrats, wobei die nicht mit Releaseschicht und Kaschierkleber bzw. Heißsiegellack beschichteten Bereiche auf dem ersten Trägersubstrat haften bleiben.

Als Trägersubstrat kommen beispielsweise Trägerfolien, vorzugsweise flexible Kunststofffolien, beispielsweise aus PI, PP, OPP, PE, PPS, PEEK, PEK, PEI, PSU, PAEK, LCP, PEN, PBT, PET, PA, PC, COC, POM, ABS, PVC Fluorpolymere wie Teflon und dergleichen in Frage. Die Trägerfolien weisen vorzugsweise eine Dicke von 5 - 700 µm, bevorzugt 5 - 200 µm, besonders bevorzugt 36 - 125 µm auf.

Ferner können als Trägersubstrat auch Metallfolien, beispielsweise AI-, Cu-, Sn-, Ni-, Fe- oder Edelstahlfolien mit einer Dicke von 5 - 200 µm, vorzugsweise 10 bis 80 µm, besonders bevorzugt 10 - 40 µm dienen. Die Folien können auch oberflächenbehandelt, beschichtet oder kaschiert beispielsweise mit Kunststoffen oder lackiert sein.

Ferner können als Trägersubstrate auch Papier oder Verbunde mit Papier, beispielsweise Verbunde mit Kunststoffen mit einem Flächengewicht von 20 - 500 g/m², vorzugsweise 40 - 200 g/m² verwendet werden.

Das Trägersubstrat kann bereits vollflächig oder partiell mit einer oder mehreren Schichten beschichtet sein.
Diese Schicht(en) kann/können optische, optisch aktive, elektrisch leitfähige, elektrisch aktive oder magnetische Eigenschaften aufweisen.

In einem ersten Schritt b) wird auf das Trägersubtrat ein schwach haftender Lack oder eine schwach haftende Beschichtung partiell auf dieses erste Trägersubstrat aufgebracht. Der Lack kann dabei in Form von Linien, Mustern, Bahnen, Symbolen, Zeichen und dergleichen aufgebracht werden.
Dabei wird der Lack in jenen Bereichen aufgebracht, in denen im fertigen Produkt nicht mit der strukturierten Schicht versehene Bereiche vorliegen sollen.

Die partielle Aufbringung des auf dem Trägersubstrat schwach haftenden Lacks kann durch ein beliebiges Verfahren, beispielsweise durch Tiefdruck, Flexodruck, Siebdruck, Digitaldruck und dergleichen erfolgen.

Als schlecht haftende Lackschichten kommen insbesondere beispielsweise Lacke oder Beschichtungen auf Methacrylatbasis, auf Basis von Polyamid-, Polyethylen-, Fluorpolymerwachs, Silikon-, Stärke- oder dünne Ölschichten in Frage.

Die Dicke dieser Schicht kann zwischen 0,1 und 100 g/m² betragen.

Ist die Haftung der zu strukturierenden Schicht auf dem Trägersubstrat schlecht, kann dieser Schritt entfallen und die Strukturierung nur mit den Schichten c) - f) erfolgen.

Anschließend wird eine zu strukturierende Schicht c), aufgebracht.
Die zu strukturierende Schicht c) kann aber auch aus mehreren Schichten bestehen, die jeweils mit demselben Muster strukturiert werden.

Diese Schicht besteht beispielsweise aus einem Metall, einer Metallverbindung, oder einer Legierung. Als Metallschicht sind Schichten aus AI, Cu, Fe, Ag, Au, Cr, Ni, Zn und dergleichen geeignet. Als Metallverbindungen sind beispielsweise Oxide oder Sulfide von Metallen, insbesondere TiO₂, Cr-Oxide, ZnS, ITO, ATO, FTO, ZnO, Al₂O₃ oder Siliciumoxide geeignet. Geeignete Legierungen sind beispielsweise Cu-Al Legierungen, Cu-Zn Legierungen und dergleichen.
Ferner kann die zu strukturierende Schicht aus organischen oder anorganischen Halbleitermaterialien, wie beispielsweise Ge, Si, Pentacen, Fullerenen oder organischen oder anorganischen Dielektrika wie BCB, PVA, PV cinamat, COC und dergleichen bestehen.
Unter Fullerenen werden C₆₀, C₇₀, C₇₆, C₈₀, C₈₂, C₈₄, C₈₆, C₉₀, C₉₄ verstanden.

Die zu strukturierende Schicht c) kann im Prinzip aber auch eine beliebige Lackschicht sein.

### Die Dicke dieser Schicht beträgt 5 nm - 1 µm, bevorzugt 5 - 200 nm

Die Aufbringung der zu strukturierenden Schicht erfolgt vorzugsweise mittels eines Vakuumaufdampfverfahrens, durch Lackieren, Sprühen oder durch bekannte Druck- bzw. Beschichtungsverfahren.

Anschließend wird auf diesen Schichtaufbau eine Kaschier- oder Heißklebeschicht aufgebracht, die register- und deckungsgleich zur Releaseschicht ausgeführt ist.

Als zweites Trägersubstrat kommen beispielsweise vorzugsweise flexible Kunststofffolien, beispielsweise aus Pl, PP, OPP, PE, PPS, PEEK, PEK, PEI, PSU, PAEK, LCP, PEN, PBT, PET, PA, PC, COC, POM, ABS, PVC Fluorpolymere wie Teflon und dergleichen in Frage. Die Trägerfolien weisen vorzugsweise eine Dicke von 5 - 700 µm, bevorzugt 5 - 200 µm, besonders bevorzugt 6 bis 36 µm auf.

Ferner können als Trägersubstrat auch Metallfolien, beispielsweise Al-, Cu-, Sn-, Ni-, Fe- oder Edelstahlfolien mit einer Dicke von 5 - 200 µm, vorzugsweise 10 bis 80 µm, besonders bevorzugt 10 - 40 µm dienen. Die Folien können auch oberflächenbehandelt, beschichtet oder kaschiert beispielsweise mit Kunststoffen oder lackiert sein.

Ferner können als Trägersubstrate auch Papier oder Verbunde mit Papier, beispielsweise Verbunde mit Kunststoffen mit einem Flächengewicht von 20 - 500 g/m², vorzugsweise 40 - 200 g/m² verwendet werden.

Die Dicke der Releaseschicht b) kann in einem weiten Bereich schwanken.

Beträgt die Dicke dieser Releaseschicht ca. 0,1 - 20 g/m², muss jedenfalls das zweite Trägersubstrat zukaschiert werden, das anschließend wieder zusammen mit der Kaschierklebeschicht und der Releaseschicht abgezogen werden kann.

Wird eine Releaseschicht höherer Dicke verwendet, etwa einer Dicke von > 20 g/m² kann die Zukaschierung eines zweiten Trägersubstrats entfallen und die Releaselackschicht mit der darüber befindlichen zu strukturierenden Schicht direkt abgezogen werden, da die Releaseschicht dann eine ausreichende Eigenstabilität aufweist.

Das beschriebene Verfahren erlaubt eine Strukturierung verschiedenster aufgedampfter, lackierter oder gedruckter Schichten ohne das Material an jenen Stellen zu beschädigen, die auf dem ersten Trägersubstrat verbleiben sollen. Dies sind beispielsweise lösungsmittelempfindliche Schichten, wie organische Halbleiterschichten oder dergleichen.
Analoges gilt für Schichten die auf bereits auf dem ersten Trägersubstrat vorhandenen partiellen oder vollflächigen, sensiblen, beispielsweise lösungsmittelempfindlichen, mechanisch oder thermisch empfindlichen Schichten strukturierten werden sollen, wobei diese Schicht nicht beschädigt oder beeinträchtigt werden soll..

Durch das erfindungsgemäße Verfahren können auf einfache und sichere Weise beispielsweise Polymerelektronik-Bauteile, wie Dioden, Transistoren, Kondensatoren oder Sensoren hergestellt werden, aber auch integrierte Schaltkreise aus diesen Bauteilen.

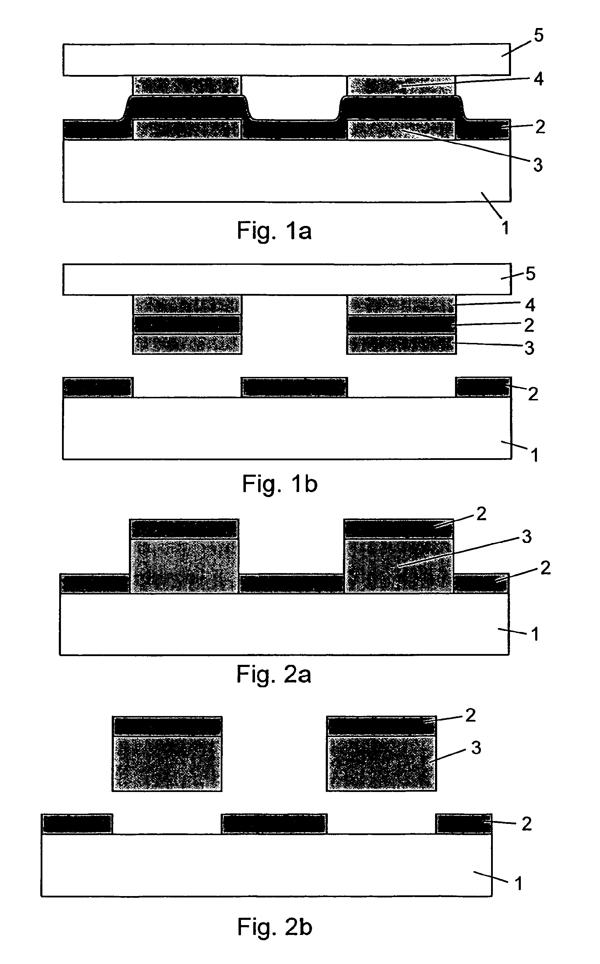

19n den Figuren 1 bis 2 sind erfindungsgemäße Ausführungsformen der Erfindung dargestellt, wobei a) jeweils den Aufbau und b) den Zustand nach Abziehen des Trägersubstrats bzw. Ablösen der Releaseschicht darstellt.

In den Figuren bedeuten 1 die Trägerfolie, 2 die zu strukturierende Schicht, 3 den Releaselack, 4 eine Kaschierkleberschicht und 5 das zweite Trägersubstrat bedeuten.

## Patentansprüche

1. Verfahren zur Herstellung partieller anorganischer oder organischer Strukturen, **gekennzeichnet durch** folgende Verfahrensschritte:
a) Bereitstellen eines ersten Trägersubstrats, das gegebenenfalls bereits eine vollflächige oder partielle Beschichtung aufweisen kann,
b) ggf. Aufbringung einer partiellen Releaseschicht, die zur Schicht a) eine geringere Haftung aufweist, als die Schicht c) zur Schicht a), wobei die partielle Releaseschicht ein negatives Abbild der strukturierten Schicht darstellt,
c) vollflächige Aufbringung einer oder mehrerer zu strukturierende(r) Schicht(en) mittels eines Beschichtungsverfahrens
d) ggf. registergenaue Bedruckung der Schicht c) mit einem Kaschierkleber oder einem Heißsiegellack, der deckungsgleich mit der Schicht b) erfolgt, bzw. ein negatives Abbild der zu strukturierenden Schicht bildet
e) ggf Kaschieren des Schichtaufbaus a) - d) mit einem zweiten Trägersubstrat,
f) Abziehen des zweiten Trägersubstrats, wobei die nicht mit Releaseschicht und Kaschierkleber bzw. Heißsiegellack beschichteten Bereich auf dem ersten Trägersubstrat haften bleiben.

2. Verfahren nach Anspruch 1, **dadurch gekennzeichnet, dass** die Dicke der Releaseschicht 0,1 bis 100 g/m² beträgt.

3. Verfahren nach Anspruch 2, **dadurch gekennzeichnet, dass** die Dicke der Releaseschicht b) mehr als 20 g/m² beträgt und Schritt e) nicht durchgeführt wird und in Schritt f) die Releaselackschicht abgezogen wird.

4. Verfahren nach Anspruch 1, **dadurch gekennzeichnet, dass** Schicht c) zu Schicht a) eine schlechte Haftfähigkeit aufweist, wodurch Schritt b) nicht durchgeführt wird.

5. Verfahren nach einem der Ansprüche 1 bis 4, **dadurch gekennzeichnet, dass** die Dicke der in Schritt c) aufgebrachten Schicht 5 nm bis 1 µm beträgt.

6. Verfahren nach einem der Ansprüche 1 bis 5, **dadurch gekennzeichnet, dass** die Schicht c) durch Drucken, Lackieren, Sprühen oder mittels eines Vakuumbeschichtungsverfahrens aufgebracht wird.

7. Verfahren nach einem der Ansprüche 1 bis 6, **dadurch gekennzeichnet, dass** Schicht c) aus einem Metall, einer Metallverbindung, einer Legierung, aus anorganischen oder organischen Halbleitermaterialien oder Dielektrika besteht.

8. Verfahren nach einem der Ansprüche 1 bis 6, **dadurch gekennzeichnet, dass** die Schicht c) eine Lackschicht ist.

9. Verfahren nach einem der Ansprüche 1 bis 8, **dadurch gekennzeichnet, dass** die Schicht c) aus mehreren Einzelschichten besteht.

10. Verfahren nach einem der Ansprüche 1 bis 9, **dadurch gekennzeichnet, dass** das erste Trägersubstrat bereits eine oder mehrere vollflächige oder partielle Schichten aufweist.

11. Verwendung der nach einem Verfahren nach den Ansprüchen 1 bis 10 hergestellten Schichten in oder als Polymerelektronikprodukte(n).
